(19) Europäisches Patentamt
European Patent Office
Office européen des brevets

(11) EP 2 403 051 A1

(12) EUROPEAN PATENT APPLICATION
published in accordance with Art. 153(4) EPC

(43) Date of publication:
04.01.2012 Bulletin 2012/01

(51) Int Cl.:
H01M 14/00 (2006.01)     H01L 31/04 (2006.01)

(21) Application number: 10745973.7

(22) Date of filing: 24.02.2010

(86) International application number:
PCT/JP2010/001242

(87) International publication number:
WO 2010/098088 (02.09.2010 Gazette 2010/35)

(84) Designated Contracting States:
AT BE BG CH CY CZ DE DK EE ES FI FR GB GR
HR HU IE IS IT LI LT LU LV MC MK MT NL NO PL
PT RO SE SI SK SM TR

(30) Priority: 25.02.2009 JP 2009043119

(71) Applicants:
• Tokyo Electron Limited
Tokyo 107-6325 (JP)
• Kyushu Institute of Technology
Kitakyushu-shi, Fukuoka 804-8550 (JP)

(72) Inventors:
• HAYASHI, Hiroaki
Tokyo 107-6325 (JP)
• SHIRATSUCHI, Ryuichi
Kitakyushu-shi
Fukuoka 804-8550 (JP)
• OHKUBO, Suehiro
Kitakyushu-shi
Fukuoka 804-8550 (JP)
• TAKASAKI, Masato
Kitakyushu-shi
Fukuoka 804-8550 (JP)
• HAYASE, Shuzi
Kitakyushu-shi
Fukuoka 808-0196 (JP)

(74) Representative: Diehl & Partner GbR
Patentanwälte
Augustenstrasse 46
80333 München (DE)

(54) **METHOD AND DEVICE FOR DYE ADSORPTION FOR PHOTOSENSITIZING DYE, PROCESS AND APPARATUS FOR PRODUCING DYE-SENSITIZED SOLAR CELL, AND DYE-SENSITIZED SOLAR CELL**

(57)     A method for adsorption of a photosensitizing dye includes adsorbing the photosensitizing dye to the layer of an electrode material that functions as the working electrode of a dye-sensitized solar cell, within a reaction vessel containing a solution of the photosensitizing dye, wherein a flow of the photosensitizing dye solution is generated by means of a flow generation part in a direction perpendicular to the electrode material layer, a direction parallel thereto or both, and the flow rate of the photosensitizing dye solution to the electrode material layer is higher than the diffusion velocity of the photosensitizing dye.

FIG. 1

**Description**

**TECHNICAL FIELD**

The present disclosure relates to a method and apparatus for fast dye adsorption in the production of a dye-sensitized solar cell, a method and apparatus for producing dye-sensitized solar cell by using the method for fast dye adsorption, and a dye-sensitized solar cell.

**BACKGROUND**

A dye-sensitized solar cell having a general structure includes a transparent conductive thin film formed on one surface of a transparent substrate; a working electrode having a porous semiconductor layer made of metal oxide particles adsorbed with a dye, which is formed on a surface of the transparent conductive thin film; a counter electrode consisting of a conductive substrate having a catalyst such as platinum or carbon, which is counter to the working electrode, and an electrolyte between the working electrode and the counter electrode.

A crystalline silicon solar cell or thin film silicon solar cell is produced by utilizing a high precision process such as plasma CVD or high temperature crystal growth process. On the contrary, the dye-sensitized solar cell may be produced by preparing electrodes through the application of metal oxide semiconductor particles in the form of paste on a transparent substrate such as glass, followed by calcination in a conventional system including transportation, application and calcination processes, such as belt conveyor furnace, under normal atmospheric pressure. Furthermore, the fast transportation process leads to mass production easily. Also, the metal oxide semiconductor particles used as the raw material of electrodes is inexpensive as compared with other solar cell materials (e.g., silicon). In the light of foregoing, the dye-sensitized solar cell is expected to contribute to a supply of solar cell in a low price and a growing prevalence of solar cell.

A dye adsorption process in the production of the dye-sensitized solar cell is, however, performed for about half of a day in a dye-dissolved solution under atmospheric pressure. Accordingly, in order to raise the production efficiency of the dye-sensitized solar cell, it is required to rapidly perform the dye adsorption process in a short time.

Several attempts have been made to perform the dye adsorption process in a short time by using a metal complex-based dye or an organic dye other than the metal complex dye. For example, a substrate with porous semiconductor layer made of metal oxide particles may be dipped in a pressurized fluid comprising a Ru-complex and carbon dioxide, which is present in the condition of a temperature and pressure for obtaining supercritical carbon dioxide fluid, for 30 minutes, to obtain a film adsorbed with the Ru-complex dye. The film has been suggested to have a photoelectric converting efficiency higher than that of film obtained from the prior dipping technique *(see* Patent Document 1).

Also, Patent Documents 2 and 3 disclose a dye adsorption process of a porous metal oxide layer with a Ru complex-based dye or an organic dye other than the Ru-complex dye, in which a reaction time for adsorption may be suitably adjusted depending on the type of the organic dye in the range of 4 to 24 hours and 30 minutes to 24 hours, respectively, by heating a dye-contained solution. However, the time required for dye adsorption is not clear.

In general, in order to obtain a dye-sensitized solar cell having an efficiency exceeding 9%, a Ru complex-based dye, e.g., black dye (tris(isothiocyanate-ruthenium(II)-2,2':6',2"-terpyridine-4,4,4"-tricarboxylic acid, tris-tetrabutyl ammonium sulfate)) needs to be used, however, it requires an dipping time of 24 hours for good adsorption of the dye *(see* Patent Document 4).

A porous body consisting of metal oxide semiconductor particles adsorbing a dye is required to have strong bonding between particles and between particles and a transparent conductive metal oxide film, so as to prevent delamination for a long-time dipping in a solution containing a dye of a static state. Such strong bond may be obtained by calcining a transparent substrate in a temperature less than or equal to its softening point. For example, sodalime glass which is used often is heat-treated in a temperature less than or equal to its softening point (570 °C) to form bond between particles, and further followed by particle surface coating by way of post-treatment of titanium tetrachloride to obtain strong bond between particles.

Patent Document 3 discloses the enhancement of light scattering property as to the surface of a porous body consisting of metal oxide semiconductor particles, by increasing the distance and inclining toward the glass surface to increase particle diameter. Also, Patent Document 5 discloses a working electrode where the film has a small particle diameter is wholly covered by the film having a large particle diameter. Such a surface is considered to have high surface roughness as compared with the conventional film consisting of uniform layers.

There is an effort to achieve high photoelectric conversion efficiency in an interface between metal oxide semiconductor particles and a transparent conductive metal oxide thin film. A transparent conductive metal oxide thin film consisting of polycrystalline aggregates, e.g., glass having the thin film of fluorine-doped tin oxide thereon is used in the production of a dye-sensitized solar cell. The thin film is generally formed by chemical vapor deposition, in which crystalline orientation may be changed by the adjustment of source gas. As a result, the surface roughness can be changed (*see* Patent Document 6).

Also, there is a technique forming a working electrode having relatively large unevenness on the surface of a porous body obtained through forming relatively large protrusions by silica particles on glass substrate and then applying fluorine-doped tin oxide thereon *(see* Patent Document 7).

On the contrary, there is a technique improving the photoelectric conversion efficiency of a dye-sensitized solar cell by polishing the surface of a transparent conductive metal oxide film formed *(see* Patent Document 8).

Also, a tandem type of dye-sensitized solar cell having a transparent conductive layer of fluorine-doped tin oxide in the middle part of a porous metal oxide body has suggested as a cell structure, which is difficult to adsorb a dye *(see* Patent Document 9).

The structure of a photoelectric conversion device is not limited to configurations described above. For example, as suggested in Patent Document 10, there is a structure that a porous semiconductor metal oxide layer adsorbing a dye is formed on a porous collection electrode made of metal, e.g., metal mesh, perforated metallic plate or foil. As to such a structure, techniques forming a porous semiconductor metal oxide layer as described above are used.

Also, as suggested in Patent Document 11, in the case of a structure that a porous layer is filled in the hole and covers opposite surface side, a transparent conductive layer is formed on a porous collection electrode, and then the dense film of metal oxide semiconductor is coated on the surface of metal layer to laminate a porous semiconductor metal oxide layer, in which techniques forming a porous semiconductor metal oxide layer as described above are also used.

Also, for dye adsorption to a porous semiconductor metal oxide film, a tandem structure of solar cell is developed. In that case, it is required to adsorb a dye showing sensitivity at short-wavelength region and a dye showing sensitivity at long-wavelength region. Also, on the plane in which light is incident, a porous layer adsorbed with a long-wavelength dye should be arranged on a porous layer adsorbed with a short-wavelength dye. This arrangement is disclosed in Patent Document 1.

It is preferred that a solution for dye adsorption performs the adsorption at a temperature less than or equal to its boiling point, and an adsorption device is kept in its closed state to prevent increasing the concentration of a dye-contained solution, and further the dye adsorption is performed in an adsorption device having a reflux function, as disclosed in Patent Document 12.

[Prior Art Documents]

Patent Documents

Patent Document 1: Japanese laid-open publication No. 2008-071535
Patent Document 2: Japanese laid-open publication No. 2003-197280
Patent document 3: Japanese laid-open publication No. 2001-076776
Patent document 4: Japanese laid-open publication No. 2007-128869
Patent document 5: Japanese laid-open publication No. 2006-049082
Patent document 6: Japanese laid-open publication No. 2006-032227
Patent document 7: Japanese laid-open publication No. 2006-009740
Patent document 8: PCT International Publication No. WO 2006/38495
Patent document 9: Japanese laid-open publication No. 2008-016405
Patent document 10: Japanese laid-open publication No. 2001-283941
Patent document 11: Japanese laid-open publication No. 2007-305351
Patent document 12: Japanese laid-open publication No. 7-249790.

A dye consisting of a Ru-complex has high photoelectric conversion efficiency, however, requires a long adsorption time. A dye dissolved in a pressurized fluid comprising supercritical carbon dioxide fluid may be adsorbed in the surface of a porous body consisting of oxide semiconductor particles within a very short time of about 30 minutes. However, in order to the pressurized fluid, it is required to use a dye adsorption device including large-sized pressure vessel capable of enduring a pressure near 100 atm. Since the addition of the pressure performance to the large cell production equipments raises the cost of the equipment, it is contrary to the reduction of production cost which is required for a dye-sensitized solar cell industry.

Accordingly, there is a need to develop a method and device for adsorbing a dye within a short time without using a high pressure near to 100 atm. Furthermore, in order to reduce production cost of a dye-sensitized solar cell and enhance the photoelectric conversion efficiency of the dye-sensitized solar cell in a system comprising a dye adsorption procedure, the conditions for enhancing adsorption in the device developed; the surface state of a porous body consisting of oxide semiconductor particles required to enhance adsorption; and the state of interface between a porous body consisting of oxide semiconductor particles and a transparent substrate; and the surface state of a transparent substrate required to prevent film delamination during adsorption are need to be in detail studied.

The present disclosure provides some embodiments of a method and device for adsorption of a photosensitizing dye, a process and apparatus for producing a dye-sensitized solar cell, and a dye-sensitized solar cell, which can reduce production cost of a dye-sensitized solar cell and enhance the photoelectric conversion efficiency of the dye-sensitized solar cell in a system comprising a dye adsorption procedure.

## SUMMARY

According to one embodiment of the present disclosure, there is provided a method for adsorption of a photosensitizing dye, comprising adsorbing the photosensitizing dye to an electrode material layer that functions as a working electrode of a dye-sensitized solar cell, within a reaction vessel containing a solution of the photosensitizing dye, wherein a flow of the photosensitizing dye solution is generated by means of a flow generation part in at least one of a direction perpendicular to the electrode material layer and a direction parallel thereto; and the flow rate of the photosensitizing dye solution to the electrode material layer is higher than the diffusion velocity of the photosensitizing dye.

According to another embodiment of the present disclosure, there is provided a method for producing a dye-sensitized solar cell, which includes forming a film to be an electrode material layer after calcination, calcining the film, and adsorbing a photosensitizing dye to the electrode material layer in a successive production line to produce a working electrode of the dye-sensitized solar cell, wherein the photosensitizing dye adsorption is performed by the method of the photosensitizing dye adsorption described above.

According to another embodiment of the present disclosure, there is provided a device for adsorption of a photosensitizing dye, which adsorbs the photosensitizing dye to an electrode material layer that functions as a working electrode of a dye-sensitized solar cell, within a reaction vessel containing a solution of the photosensitizing dye, comprising a flow generation part for generating a flow of the photosensitizing dye solution in at least one of a direction perpendicular to the electrode material layer and a direction parallel thereto, wherein the flow rate of the photosensitizing dye solution to the electrode material layer, which is generated by the flow generation part, is higher than the diffusion velocity of the photosensitizing dye.

According to another embodiment of the present disclosure, there is provided an apparatus for producing a dye-sensitized solar cell, which comprises forming a film to be an electrode material layer after calcination, calcining the film, and adsorbing a photosensitizing dye to the electrode material layer in a successive production line to produce a working electrode of the dye-sensitized solar cell, wherein the photosensitizing-dye adsorption is performed by the device for adsorption of the photosensitizing-dye described above.

According to another embodiment of the present disclosure, there is provided a dye-sensitized solar cell which adsorbs a photosensitizing dye to an electrode material layer that functions as a working electrode, wherein the photosensitizing dye adsorption to the electrode material layer is performed by the method of the photosensitizing-dye adsorption described above.

## EFFECTS OF THE PRESENT DISCLOSURE

According to the present disclosure, it is possible to provide a method and device for adsorption of a photosensitizing dye, a method and apparatus for producing a dye-sensitized solar cell, and a dye-sensitized solar cell, which can reduce production cost of a dye-sensitized solar cell and enhance the photoelectric conversion efficiency of the dye-sensitized solar cell in a system comprising a dye adsorption procedure.

## BRIEF DESCRIPTION OF THE DRAWINGS

FIG. 1 is a view illustrating the configuration of a device for dye adsorption of a photosensitizing dye according to one example of the present disclosure.
FIG. 2 is a view illustrating the configuration of a device for dye adsorption of a photosensitizing dye according to another example of the present disclosure.
FIG. 3 is a view schematically illustrating the structure of a working electrode for one example of the present disclosure.
FIG. 4 is a view schematically illustrating the structure of a dye-sensitized solar cell in for one example of the present disclosure.
FIG. 5 is a view illustrating the configuration of a device for dye adsorption of a photosensitizing dye according to example of the present disclosure.

**FIG. 6** is a view illustrating the configuration of another device for dye adsorption of a photosensitizing dye according to example of the present disclosure.

**FIG. 7** is a view illustrating the configuration of another device for dye adsorption of a photosensitizing dye according to example of the present disclosure.

**FIG. 8** is a view illustrating the configuration of still another device for dye adsorption of a photosensitizing dye according to example of the present disclosure.

**FIG. 9** is a view illustrating the configuration of still another device for dye adsorption of a photosensitizing dye according to example of the present disclosure.

**FIG. 10** is a view illustrating the configuration of still another device for dye adsorption of a photosensitizing dye according to example of the present disclosure.

**FIG. 11** is a view illustrating the configuration of still another device for dye adsorption of a photosensitizing dye according to example of the present disclosure.

**FIG. 12** is a view illustrating the configuration of still another device for dye adsorption of a photosensitizing dye according to example of the present disclosure.

**FIG. 13** is a view illustrating the configuration of still another device for dye adsorption of a photosensitizing dye according to example of the present disclosure.

**FIG. 14** is a view illustrating the configuration of still another device for dye adsorption of a photosensitizing dye according to example of the present disclosure.

**FIG. 15** is a view illustrating the configuration of still another device for dye adsorption of a photosensitizing dye according to example of the present disclosure.

## DETAILED DESCRIPTION

Embodiments of the present disclosure will now be in detail described in detail with reference to the accompanying drawings.

A working electrode for practicing a dye adsorption treatment in a dye adsorption process is maintained under relatively mild conditions of normal atmospheric pressure or a pressure not exceeding 10 atm, and a dye-contained solution is generally maintained in its static state so as to avoid the delamination from the substrate of a porous metal oxide layer. The dye adsorption depends on electric double layer generated in the interface between the dye-contained solution and metal oxide semiconductor particles. The electric double layer is changed by applying external motion or potential gradient. This change is related to the zeta potential of the interface. The zeta potential is an important factor determining a dye adsorption rate, which is known to depend on potential, motion, pressure, temperature and concentration (*see* Surface and Interface, Nobuatsu Watanabe, Shaw Watanabe, Yasukatsu Tamai et al., KYORITSU SHUPPAN Co., LTD, 1.2 Electrokinetic phenomenon, pp7-27 (1973)).

The present disclosure suggests a method of changing the electric double layer of the interface between the dye-contained solution and the metal oxide semiconductor particles to increase a dye adsorption rate in the solution. More specifically, the present disclosure suggests an optimum method for activating the transfer of a dye to the surface of metal oxide semiconductor particles by means of the motion by the rotation of the solution, an atmospheric pressure and temperature, the concentration of the solution, and the application of a voltage. Also, in order to provide a porous metal oxide semiconductor layer having a structure suitable for dye adsorption without destroying the structure of the layer, the present disclosure refers to a metal oxide porous body having a higher structural strength obtained by forming a dense metal oxide layer in a state that the surface roughness of the metal oxide thin film having a transparent conductivity is maintained.

The present disclosure will be described with regard to a device of dye adsorption for practicing the present disclosure. Also, the disclosure below is given for the purpose of one embodiment only, and various example modes satisfying same physical and chemical conditions are within the scope of the present disclosure.

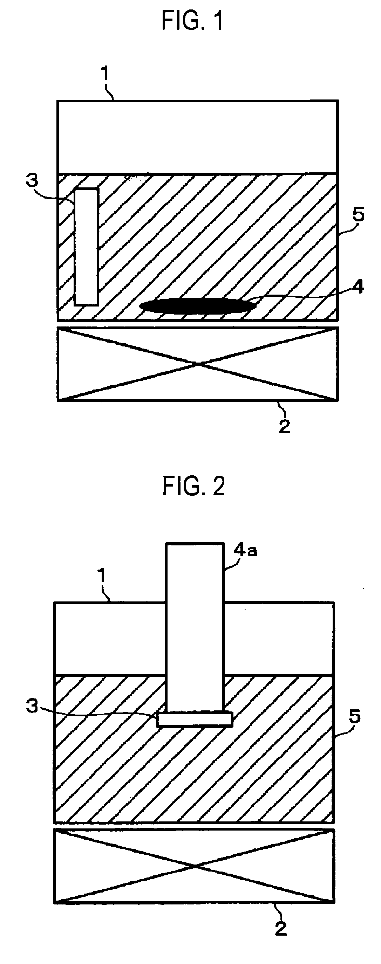

The examples of the present disclosure will be described with reference to **FIGS. 1** and **2. FIG. 1** illustrates the configuration of a device for dye adsorption of a photosensitizing dye used in Example 1 of the present disclosure. The dye adsorption device for adsorbing a photosensitizing dye has a cylindrical sealing vessel 1 for receiving a dye-contained solution 5, a stirrer 4 for generating a flow in the dye-contained solution 5, and a heater 2 with the driving unit of the stirrer 4. In Example 1, the flow is generated in the dye-contained solution 5 by the stirrer 4 driven by the heater 2 in the circumferential direction at the side of the cylindrical sealing vessel 1, and a working electrode substrate 3 which is obtained by forming a porous film consisting of metal oxide particles on a transparent conductive substrate is arranged in contact with the cylindrical side of the sealing vessel 1, thereby generating a flow parallel to the surface of the porous film in the dye-contained solution. By the flow, the dye which is present in the dye-contained solution 5 transfers at a rate higher than the diffusion velocity of the dye in the dye-contained solution 5 under static state, to increase the adsorption rate of the dye. The transfer rate of the dye-contained solution 5 may be changed from 0 of its static state to the rate of about 50 cm/s. In the case of the dye adsorption according to Example 1 illustrated in **FIG. 1,** if the rate is about 15 cm/s or more, a time which is required for dye adsorption may be sufficiently shortened. Also, the dye in the dye-contained solution 5 transfers at a rate higher than its diffusion velocity, thereby reducing the association between the dye particles, as compared with that in the static state of the solution. Also, the heater 2 can increase the inner pressure of the closed vessel 1 under relatively mild conditions, and the inner pressure is preferably from normal atmospheric pressure to about 1.5 atm.

**FIG. 2** illustrates the configuration of a device for adsorbing a photosensitizing dye used in Example 2 of the present disclosure. The dye-adsorption device has a closed cylindrical sealing vessel 1 for receiving a dye-contained solution 5, a cylindrical rotor 4a for generating a flow in the dye-contained solution 5, and a heater 2. In Example 2, a working electrode substrate 3 which is obtained by forming a porous film consisting of metal oxide particles on a transparent conductive substrate is arranged in the front end of the cylindrical rotor 4a. The dye-contained solution 5 puts in the sealing vessel 1 (or an opened cylindrical vessel such as beaker), the working electrode substrate 3 is dipped in the dye-contained solution 5, followed by rotating the rotor 4a to which the working electrode substrate 3 is attached, thereby generating forced convection upwards in the dye-contained solution 5. By the forced convection, the dye-contained solution 5 transfers in the direction perpendicular and parallel to the porous film of the working electrode substrate 3 in a region adjacent to the surface of the working electrode substrate 3. That is, the flow of the dye-contained solution 5 is generated in the direction perpendicular to the surface of the porous film together with in a direction parallel thereto. Thereby, the dye present in the dye-contained solution 5 transfers at a rate higher than the diffusion velocity of the dye present in the dye-contained solution 5 under static state. The vertical transfer rate of the dye-contained solution 5 may be changed from 0 of its static state to the rate of about 250 cm/s, but according to an aspect of dye adsorption, a transfer rate of 5 m/s to 50 m/s is preferred. Also, the dye in the dye-contained solution 5 can transfer at a rate higher than its diffusion velocity, thereby reducing the association between the dye particles, as compared with that in the static state of the solution. Although not being illustrated in drawings, the rotor 4a may be arranged in the bottom side to similarly generate the forced convection, thereby providing a motion required to the dye adsorption. In this case, if the rotor 4a is sealed, the heater 2 can increase the inner pressure of the vessel 1 under relatively mild conditions, and the inner pressure is preferably from normal atmospheric pressure to about 1.5 atm.

On using the method illustrated in **FIG. 2**, a velocity of the vertical direction (Vy) and a velocity of the horizontal direction (Vr) for the solution in a region adjacent to the porous film on the working electrode substrate 3 may be calculated from the following equations, according to the method specifically disclosed in the document [A. J. Bard, L. R. Faulkner, Electrochemical Methods fundamentals and Applications, Second Edition, John Wiley & Sons, Inc. pp335-336].

$$Vy = -0.51\omega^{3/2}v^{-1/2}y^2$$

$$Vr = 0.51\omega^{3/2}v^{-1/2}ry$$

where $\omega$ is an angular velocity and $v$ is a coefficient of viscosity. For example, when ethanol is used as a solvent, as its coefficient of viscosity is 0.0151 cm$^2$/s (20 □), Vy for the solution of 1 mm above the surface of the substrate 3 is estimated to 28 cm/s, and Vr in the 2.5 mm apart position from the rotation center is estimated to about 7 cm/s. As the distance from the rotation center is longer, the velocity in the horizontal direction becomes increased. Accordingly, the dye which is penetrated in the porous film in vertical direction is exposed to the flow forced to the lateral direction in the porous film, thereby leading to the increase of a dye adsorption rate. Therefore, it is preferred that the flow of the solvent to the porous film is generated in both vertical and horizontal directions.

Also, the dye adsorption may be carried out by placing a substrate having the porous film consisting of metal oxide particles in an applicator such as spin coater, dropping down the dye solution, and generating the penetration to the porous film by the motion in the direction vertical to the porous film and the motion in the direction horizontal to the porous film surface by way of centrifugal force.

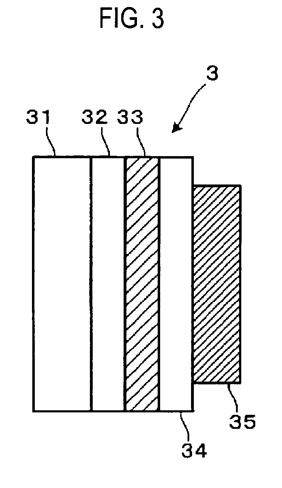

In case of the dye adsorption using the motion of the solution, the structural strength of the working electrode substrate is important. **FIG. 3** illustrates an example of the basic configuration of the working electrode used in the dye adsorption of the present disclosure. In case of a substrate 31 being a glass, particularly inexpensive sodalime glass, it needs a silicon oxide film 32 thereon so as to prevent the diffusion of alkali elements on heat-treatment. However, if the substrate is plastics such as PET or non-alkali glass such as quartz glass or borosilicate glass, the conventional flat silicon oxide film 32 is not necessary. The silicon oxide film 32 may be formed by vacuum processes such as sputtering, processes at atmospheric pressure such as thermal CVD, or the application and calcination of a coating solution comprising a silica precursor. Also, on using the application and calcination of the coating solution, the silica particles having a size of 2.5 $\mu$m or less is uniformly dispersed in the coating solution with a silica precursor and the coating solution is applied, so as to increase the confinement effect of light entered in a solar cell.

The substrate 31 (or the silicon oxide film 32) has a transparent conductive metal oxide thin film 33 and a porous metal oxide semiconductor layer 35 formed thereon to obtain a working electrode which is used in a dye-sensitized solar cell. Also, as described below, in order to increase the structural strength of the working electrode and obtain high photoelectric conversion efficiency, it is preferred that a dense metal oxide layer 34 is formed between the transparent conductive metal oxide thin film 33 and the porous metal oxide semiconductor layer 35. The dense metal oxide layer 34 is non-porous metal oxide layer and may be consisted of amorphous or crystalline particles, but it is preferred to have a density reaching 90% or more of the density of single crystal. In **FIG. 3**, the silicon oxide film 32 and the dense metal oxide layer 34 are formed.

In case that the substrate is plastics such as PET, the transparent conductive metal oxide thin film 33 may be an ITO thin film wherein tin is doped in indium oxide by way of sputtering. The ITO is a transparent conductive film having the lowest resistivity. However, other commercially available ITOs except for products for using in a dye-sensitized solar cell have low chemical stability to be difficult to endure the heat-treatment of 400 °C or higher, which is not preferred to be used in the production of a dye-sensitized solar cell.

Aluminum- or indium-doped zinc oxide is also a transparent conductive material, and often used in vacuum-based process for a silicon thin film solar cell. This material is also not preferred to be used in processes for producing a dye-sensitized solar cell due to the rise of production costs, if vacuum-based process is not necessary.

Fluorine-doped tin oxide has low resistivity as compared with ITO, but it has good chemical stability. Accordingly, it is preferred to use the fluorine-doped tin oxide in processes for producing a dye-sensitized solar cell.

The fluorine-doped tin oxide may be formed by way of spray pyrolysis wherein a solution comprising tin material such as tin tetrachloride is subjected to spraying contact by a spray on a glass substrate heated, and thermal CVD wherein the vapor of the same tin material is generated by heating and the vapor is transferred to a heated substrate to contact the substrate. As the fluorine for doping, ammonium fluoride or hydrofluoric acid is used in the spray pyrolysis, and freon gas or hydrofluoric acid is used in the thermal CVD. In order to reduce series resistance, it is preferred that the resistance of the film is low. Considering light transmittance which has conflict relation with the resistance, it is preferred that the sheet resistance is 4 to 8 $\omega$/sq and the visible light transmittance is 80 to 85 %.

The surface condition of the fluorine-doped tin oxide film may be changed by preparation conditions of a gas used to prepare the film, a substrate temperature and the others. That is, if the particle size of the polycrystalline fluorine-doped tin oxide film is increased, light confinement effect is exhibited. In order to obtain a dye-sensitized solar cell having higher photoelectric conversion efficiency, it is preferred to adjust the surface shape of the fluorine-doped tin oxide film and the structure of the porous metal oxide semiconductor layer 35, in the state that the dense metal oxide layer 34 is laminated. Also, if the porous metal oxide semiconductor layer 35 has relatively large particles to induce scattering effect, the fluorine-doped tin oxide film may be subjected to surface polishing to be flat and a solar cell having higher photoelectric conversion efficiency can be obtained.

Also, the surface condition of the fluorine-doped tin oxide film may be changed by the base surface condition. As described above, in the case of forming the silicon oxide film 32 by mixing silica particles, the silicon oxide film 32 has protrusions in the surface thereof due to the influence of silica particle shape. The fluorine-doped tin oxide film is formed on the silicon oxide film to have protrusions in the surface thereof due to the influence of the surface state of the silicon oxide film 32 which is positioned beneath the fluorine-doped tin oxide film. Accordingly, the surface state of the fluorine-doped tin oxide film may be resulted from the preparation conditions of the fluorine-doped tin oxide film in microscopic respect, while it may be resulted from both of the preparation conditions and the base surface state in much macroscopic respect. The surface state of the fluorine-doped tin oxide film may affect the contact property of the dense metal oxide layer 34 and the porous metal oxide semiconductor layer 35 to be laminated. When the fluorine-doped tin oxide film has protrusions in its surface to exhibit a corresponding surface roughness, the dense metal oxide layer 34 which is formed on the fluorine-doped tin oxide film exhibits a rough surface state due to the presence of protrusions. Thereon, the porous metal oxide semiconductor layer 35 is formed thereon so that the metal oxide particles of the porous metal oxide semiconductor layer 35 are in more contact with the dense metal oxide layer 34 to increase the contact property of the metal oxide semiconductor layer 35. Accordingly, in the dye adsorption of the present disclosure, it is preferred to form the dense metal oxide layer 34 on the transparent conductive metal oxide thin film 33 having the surface roughness due to the presence of protrusions. Also, it is preferred that the dense metal oxide layer 34 is formed by a sol-gel process or liquid phase deposition which may well cover the surface having protrusions. Furthermore, after forming the porous metal oxide semiconductor layer 35, the formation of a highly dense metal oxide layer is carried out to form a dense metal oxide layer on the surface of metal oxide particles in the porous metal oxide semiconductor layer 35, thereby increasing the contact property of the porous metal oxide semiconductor layer 35.

The dense metal oxide layer 34 is prepared to prevent the transfer of electrons from the transparent conductive metal oxide thin film 33 to an electrolyte. The dense metal oxide layer 34 may be prepared by sputtering, CVD, sol-gel process, liquid phase deposition or the others. The metal oxides such as titanium oxide, aluminum oxide and tungsten oxide are suitable as the dense metal oxide layer 34. In case of the titanium oxide, increasing thickness prevents the electron transfer to the surface of the transparent conductive film in sputtering for obtaining a film having high insulating properties. Accordingly, the titanium oxide may effectively cover a flat transparent conductive film surface, while it is difficult to completely cover a transparent conductive film surface having large protrusions.

For a covering, the precipitation of titania from liquid phase is effective. In this case, titanyl is used as a precursor, and ultraviolet treatment is carried out to facilitate the production of titania. The preparation of the film is carried out for about half of the day, but the dye-sensitized solar cell having the film inhibits electron transfer. The dye-sensitized solar cell having the dense metal oxide layer 34 exhibits photoelectric conversion efficiency higher than that of solar cells without the dense metal oxide layer. Similarly, a highly dense titania layer may be formed for a shorter time by adding a thickener to titanyl used as a raw material to obtain a coating solution, followed by coating and calcination of the coating solution. Further, niobium may be added to improve the conductivity of the film, thereby induce a higher photoelectric conversion efficiency.

The porous metal oxide semiconductor layer 35 is a layer where a dye of absorbing light is adsorbed, and the particles of titanium oxide, zinc oxide, tin oxide, tungsten oxide or the other can be used. The size of the particles is 5 nm to 400 nm, preferably 20 nm to 30 nm. The dense metal oxide layer 34 has a film having small particle size and good permeability to exhibit light confinement effect, and the particles having a size of 200 nm to 400 nm are arranged thereon to provide light scattering, thereby forming a multi-layered structure.

Also, the transparent conductive fluorine-doped tin oxide film, or tungsten or titanium metals may be provided in a region adjacent the center of the porous metal oxide semiconductor layer 35, thereby preparing a structure for improving the electron collection of the dye-sensitized solar cells. These structures arrange each of dyes having absorption edge each other on the top and the bottom porous metal oxide semiconductor layer 35 which are divided by a middle layer, to improve the correspondence with solar spectrum, thereby preparing a tandem structural dye-sensitized solar cell having high photoelectric conversion efficiency.

The structure of the working electrode is not limited to the structure illustrated **FIG. 3**, and the working electrode may be made of metal mesh, metal sheet, metallic foil, a substrate of perforated metal sheet, a substrate of perforated metallic foil in which a porous metal oxide semiconductor layer may be formed on one side or both side of the substrate, or a transparent glass and plastic material for receiving light. A counter electrode may be made of a conductive material having platinum or carbon, glass or plastics having a transparent conductive film, or metallic plate. The dye adsorbing method according to the present disclosure may be also applied in a photoelectric conversion device which is constructed by arranging a working electrode between a transparent substrate such as glass or plastics and a counter electrode, followed by sealing its center with a thermoplastic resin.

The examples of the photosensitizing dye which is adsorbed in the porous metal oxide semiconductor layer 35 and is subjected to photoelectric conversion includes metal complex-based dyes which comprise metals including Ru and organic dyes which do not comprise metal. N3, N719 and black dye can be used as the Ru complex-based dye. Indoline, xanthenes, coumarin, pherylene, cyanine, merocyanine, polyene and porphyrin dyes can be used as the organic dyes. These organic dyes may be adsorbed for 5 minutes to 48 hours, whose adsorption time is varied according to the type thereof. For example, the Ru complex-based dye are adsorbed in the particles of titanium oxide for 12 to 48 hours by way of dipping in a dye solution, which requires a longer dye adsorption time than the organic dyes.

Conventional organic solvents such as water, alcohol, acetonitrile, toluene, dimethylformamide and tetrahydrofuran can be used as an organic solvent used for dissolving the dyes.

In order to increase the adsorption rate of the metal complex-based dye to titanium oxide, it may consider to increase the concentration of the dyes. However, if the dye concentration is too high, the association between particles is generated to reduce a photoelectric conversion efficiency. Accordingly, it is preferred that the dye concentration is in the range of 0.1 mM to 1 mM.

Also, it is important to control the temperature of the dye-contained solution is controlled. The rise of the solution temperature in a closed vessel is accompanied by the increase of vapor pressure, thereby increasing the inner pressure of the vessel. It is preferable to heat the solution of dye dissolved in an organic solvent at or below the temperature of the boiling point of the solvent, however, it is more preferable to arrange additional equipment for refluxing the solvent so as to prevent the concentration rise due to evaporation. The inner pressure of the adsorption vessel is preferably in the range of 1 to 10 atm, more preferably 3 to 8 atm.

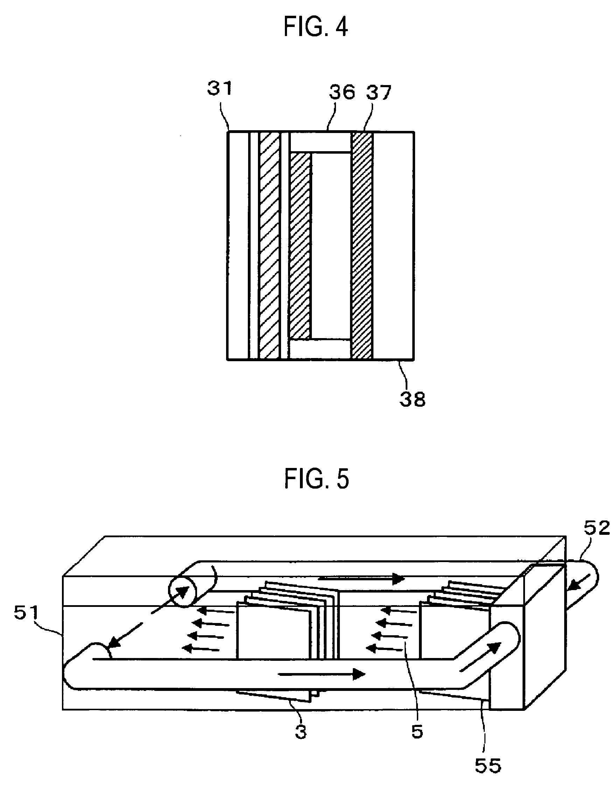

**FIG. 4** illustrates a dye-sensitized solar cell having a general cell structure, in which a spacer 36 and a counter electrode substrate 38 are further arranged in the configuration of **FIG. 3**. The counter electrode substrate 38 is prepared by depositing a platinum film 37 on one surface of a metal electrode substrate or the surface of a transparent conductive film deposited on glass or plastics. The platinum film 37 may be formed by way of sputtering, or formed in particle phase by applying a suitably diluted chloroplatinic acid on the substrate surface and then performing a heat treatment.

The platinum film has metallic reflection characteristics, thereby reflecting light reaching to the counter electrode to send to the working electrode. If the platinum film is formed in particle phase, it is preferable to use a metal electrode which is sufficiently polished until obtaining metallic luster. The electrode having metallic luster may be polished by the use of abrasives or by way of electrolytic polishing to obtain metallic luster. The metal electrode requires to be resistant against the solution comprising iodine, and it is preferable to use titanium or tungsten metal.

A dye-sensitized solar cell may be formed by laminating the counter electrode substrate 38 shown in **FIG. 4** and the substrate 3 of the working electrode side shown in **Fig. 3** by using a spacer 36 of 25 to 100 μm. The spacer 36 is resistant against iodine, and thermoplastic resins or inorganic adhesives which can adhere to glass at a low temperature are preferably used as the spacer. On the other hand, an ionomer resin (Himilan) which is processed in a sheet form may be preferably used, so as to carry out the lamination with controlling the space between the counter electrode and the working electrode. As the space between the electrodes is shorter, the series resistance component or oxidation-reduction (redox) reaction of an electrolyte solution is easily proceeded. However, as a short circuit between the working electrode and the counter electrode may be generated due to the protrusions of the surface of the porous metal oxide semiconductor film. Thus, it is preferred that the gap between the counter electrode and the working electrode is in the range of 10 to 30 μm.

The dye-sensitized solar cell is assembled by filling an electrolyte solution comprising a triiodide ($I_3^-$)/iodide ($I^-$) redox couple in an organic solvent into the gap, followed by sealing it using an adhesive such as epoxy. The examples of the electrolyte include a combination of iodine and iodide (metal iodide such as LiI, NaI, KI, CsI and $CaI_2$, or quaternary ammonium iodide such as tetraalkyl ammonium iodide, pyridinium iodide, and imidazolium iodide), a combination of brome and bromide (metal bromide such as LiBr, NaBr, KBr, CsBr and $CaBr_2$, or quaternary ammonium bromide such as tetraalkyl ammonium bromide and pyridinium bromide), sulfide such as sodium polysulfide, alkylthiol and alkyldisulfide, viologen dyes, hydroquinone, or quinone. The electrolyte may be used in a mixture form.

It is preferred that the solvent used in the electrolyte solution is a compound having low viscosity, high ionic mobility and excellent ionic conductivity. The example of the solvent include carbonate compounds such as ethylene carbonate and propylene carbonate, heterocyclic compounds such as 3-methyl-2-oxazolidinone; ether compounds such as dioxane, diethyl ether and tetrahydrofuran; linear ethers such as ethylene glycol dialkyl ether, propylene glycol dialkyl ether, polyethylene glycol dialkyl ether and polypropylene glycol dialkyl ether; alcohols such as methanol, ethanol, ethylene glycol monoalkyl ether, propylene glycol monoalkyl ether, polyethylene glycol monoalkyl ether and polypropylene glycol monoalkyl ether; polyalcohols such as ethylene glycol, propylene glycol, polyethylene glycol, polypropylene glycol and glycerine; nitrile compounds such as acetonitrile, glutardinitrile, methoxyacetonitrile, propionnitrile and benzonitrile; non-proton polar substances such as dimethyl sulfoxide and sulfolane; and water. The solvent may be used in a mixture form.

The electrolyte layer may be, for example, provided by arranging a film-type spacer between both electrodes to form a gap and filling the electrolyte solution in the gap, or by any other methods. Also, it may be provided by applying the electrolyte in the inner surface of an anode and then loading a cathode in a proper space. For the prevention of the electrolyte leakage, it is preferable to seal the cathode and its surrounding. The sealing method and the type of the sealing materials are not particularly limited.

**FIGS. 5** to **15** illustrate exemplary configurations of devices for adsorbing a photosensitizing dye. There device for adsorbing a photosensitizing dye may be, for example, used as a device for conducting a process for producing the working electrode of a dye-sensitized solar cell, which comprises the formation of a film which becomes an electrode material layer after calcination, the calcination, the adsorption of the photosensitizing dye to the electrode material layer in successive production lines. Also, in case that the electrode material layer is formed by the multilayer coating of substances such as titania, it requires repeated procedures of application → calcination (prebake) → application → calcination. Thus, the application of titania, the calcination and the adsorption of the photosensitizing dye are carried out in successive production lines to achieve an efficient and good photosensitizing-dye adsorption. In other words, such a process is carried out without delay to reduce the influence of moisture. Also, the heat generated in calcination procedure may be used in the dye adsorption procedure to promote energy conservation. Also, although not being illustrated in FIGS. 5 to 15, a unit for controlling a temperature of the dye-contained solution 5, an unit for controlling a pressure and an unit for controlling potential may be further installed.

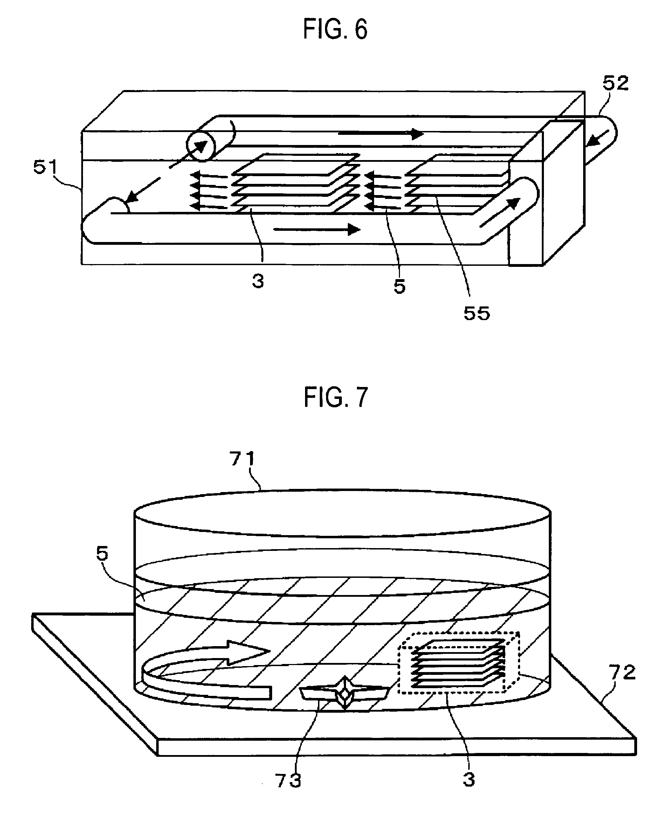

In the device illustrated in **FIG. 5**, a plurality of working electrode substrates 3 which are vertically arranged is dipped in a dye-contained solution 5 received in a sealing vessel 51, and the flow of the dye-contained solution 5 is generated by a flow generator 52 including a circulating pipe and pump which are installed in the surroundings of the sealing vessel 51, as shown by arrow in **FIG. 5**. Also, in **FIG. 5**, 55 indicates a flow guide of the dye-contained solution 5, which is consisted of a plurality of plate forms. **FIG. 6** illustrates the configuration of the substrates 3 being arranged in a horizontal direction in the device shown in **Fig. 5. FIG. 6** includes same numbers for parts corresponding to the device of **FIG. 5** and the explanation thereof is omitted.

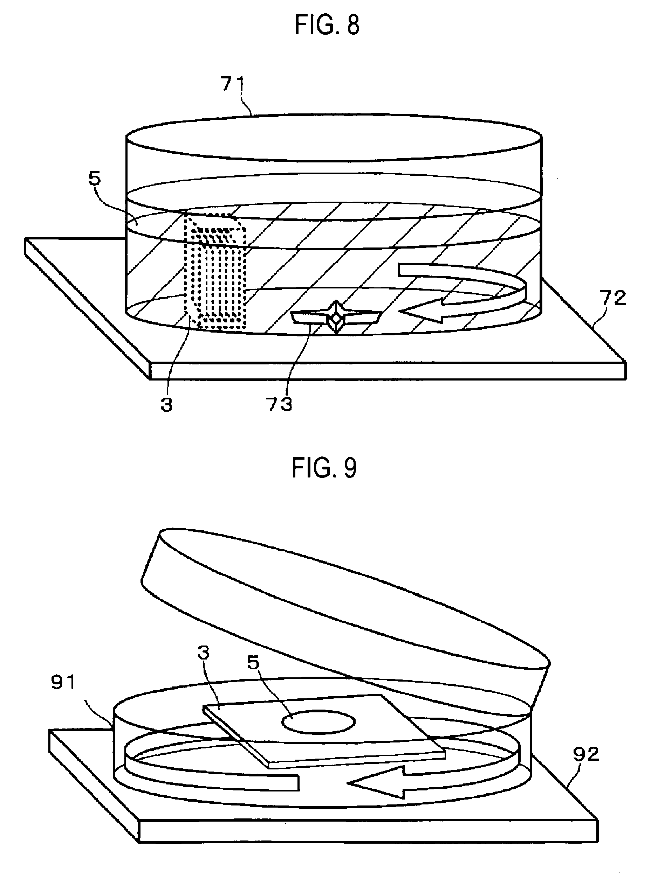

In the device illustrated in **FIG. 7**, a plurality of working electrode substrates 3 which are horizontally arranged is dipped in a dye-contained solution 5 received in a sealing vessel 71, and the flow of the dye-contained solution 5 is generated by a flow generator including a stirrer 73 which is installed within the sealing vessel 71 and a heater 72 which has the driving unit of the stirrer and is installed on the outside of the sealing vessel 71, as shown by arrow in **FIG. 7**. **FIG. 8** illustrates the configuration of the substrates 3 being arranged in a vertical direction in the device shown in **Fig. 7. FIG. 8** includes same numbers for parts corresponding to the device of **FIG. 7** and the explanation thereof is omitted.

In the device illustrated in **FIG. 9**, a working electrode substrate 3 is horizontally arranged in the vessel 91 and rotated by a rotating device 92 as shown by arrow in the drawing to generate the flow of the dye-contained solution 5 provided on the working electrode substrate 3 by centrifugal force. In this case, the working electrode substrate 3 may suitably have the square shape as well as the circular shape.

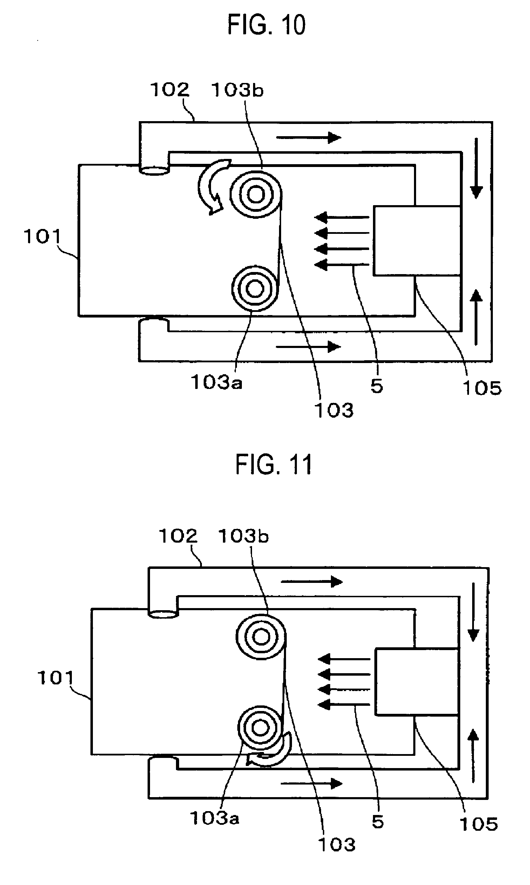

**FIG. 10** is a top-view of the device wherein a roll-shaped substrate 103 which is arranged between rollers 103a and 103b is dipped in a dye-contained solution 5 received in a sealing vessel 101, and the substrate 103 between the rollers 103a and 103b is sequentially sent in the horizontal direction, as shown by arrow in the drawing, to enable successive processing. Also, the flow of the dye-contained solution 5 is generated by a flow generator 102 including a circulating pipe and pump which are installed in the surroundings of the sealing vessel 101, as shown by arrow in the drawing. The substrate 103 is arranged in the vertical direction and counters to the flow of the dye-contained solution 5. Also, 105 in **FIG. 10** is a flow guide of the dye-contained solution 5, which is consisted of a plurality of plate forms. **FIG. 11** illustrates the disposition of the rollers 103a and 103b of **FIG. 10** to be opposite, thereby sending the substrate 103 in the reverse direction. **FIG. 11** includes same numbers for parts corresponding to the device of **FIG. 10** and the explanation thereof is omitted.

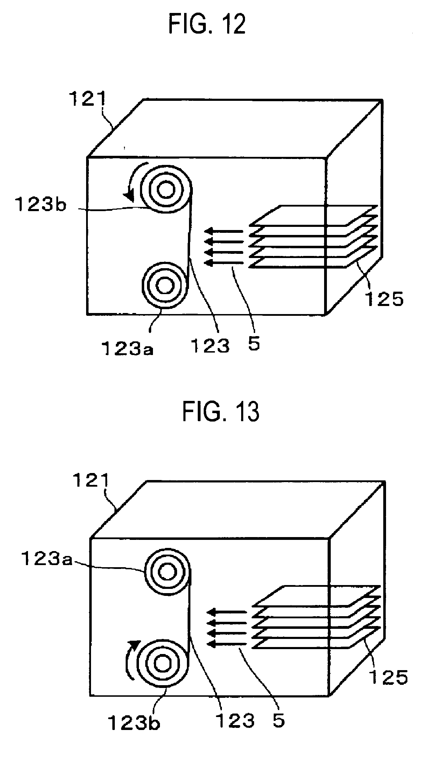

In the device of **FIG. 12**, a roll-shaped substrate 123 which is arranged between rollers 123a and 123b is dipped in a dye-contained solution 5 received in a sealing vessel 121, and the substrate 123 between the rollers 123a and 123b is sequentially sent in upward direction from below, as shown by arrow in the drawing, to enable successive processing. Also, the substrate 123 is arranged in the direction counter to the flow of the dye-contained solution 5 shown by arrow in the drawing. Also, **FIG. 12** illustrates only a guide 125 for a flow generator which generates the flow of the dye-contained solution 5 and omits the indication of other elements. **FIG. 13** illustrates the disposition of the rollers 123a and 123b of **FIG. 12** to be opposite in the vertically direction, thereby sending the substrate 103 in downward direction from above. **FIG. 13** includes same numbers for parts corresponding to the device of **FIG. 12** and the explanation thereof is omitted.

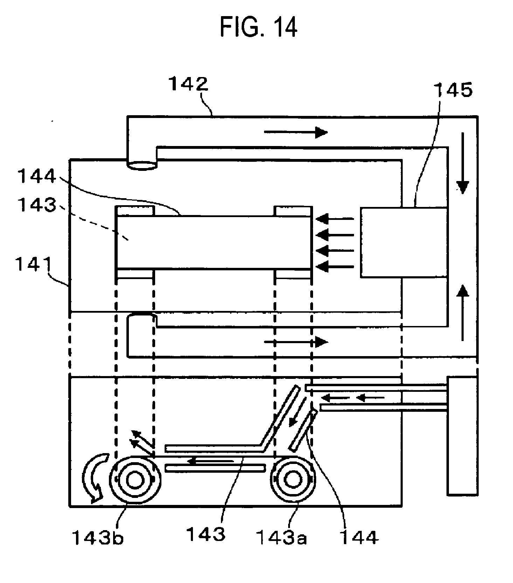

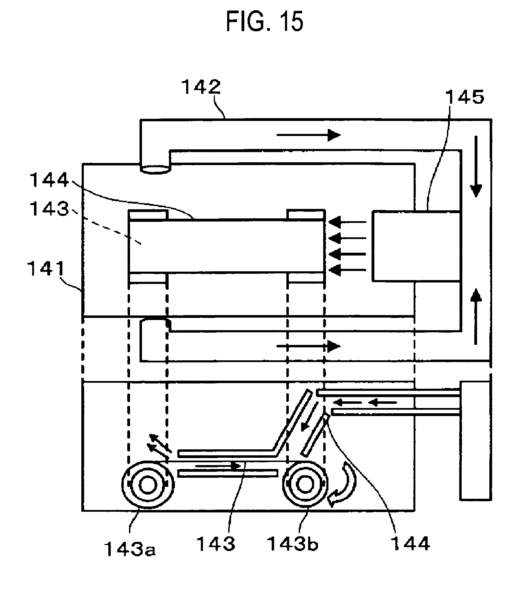

In the device of **FIG. 14**, a roll-shaped substrate 143 which is arranged between rollers 143a and 143b is dipped in a dye-contained solution 5 received in a sealing vessel 141, and the substrate 143 between the rollers 143a and 143b is sequentially sent in the horizontal direction, as shown by arrow in the drawing, to enable successive processing. Also, the flow of the dye-contained solution 5 is generated by a flow generator 142 including a circulating pipe and pump which are installed in the surroundings of the sealing vessel 141, as shown by arrow in the drawing. Also, 144 and 145 indicate flow guides for directing the flow of the dye-contained solution 5 to the substrate which is arranged in the horizontal direction, among these, the guide 144 generates the flow of the dye-contained solution 5 in downward direction from above, thereby generating a flow in vertical direction for a porous metal oxide semiconductor film. **FIG. 15** illustrates the disposition of the rollers 143a and 143b of **FIG. 14** to be changed in direction reverse to the flow of the dye-contained solution 5, thereby sending the substrate 143 in direction reverse to the flow of the dye-contained solution 5, as shown by arrow in the drawing. **FIG. 15** includes same numbers for parts corresponding to the device of **FIG. 14** and the explanation thereof is omitted.

<Examples and Comparative Examples>

The following is a description of the examples of the present disclosure and the comparative examples. An FTO thin film which was made by doping fluorine on tin oxide having a size of 10mm×5mm×3mm was formed on a Low-E glass substrate (Nippon Sheet Glass, 13.2 ω/□). A porous titanium oxide thin film is formed on the FTO thin film of the FTO film substrate. The titanium oxide is a commercially available titanium oxide paste Ti-NanoxideD/SP (SOLARONIX). The paste is applied on the FTO thin film of the FTO film substrate in the range of 5mm × 5 mm by a squeeze printing method, followed by calcinating in an electric furnace at a temperature of 500 °C so as to have a film thickness of 15 $\mu$m $\pm$ 0.5 $\mu$m,

A dye (Ruthenium (Ru) organic complex N719, manufactured by SOLARONIX Co., cis-bis(isothiocyanate)bis (2,2'-bipyridyl-4,4'-dicarboxylate)-ruthenium(II) bis-tetrabutylammonium) was dissolved in ethanol to be a concentration of 0.3 mM, to be used as a solution for dye adsorbing to the porous titanium oxide thin film which is the working electrode. After the dye adsorption, the substrate was rinsed with ethanol for 30 minutes so as to remove the remaining dye attached to the whole substrate including the working electrode. Thereafter, the substrate is dried, and 3 ml of 0.1 M aqueous sodium hydroxide solution was put into a quartz glass cell and the dyed porous titanium oxide electrode was immersed therein to dissolve completely the dye, and then the absorptivity of the solution was measured by a spectrophotometer to evaluate an adsorption amount.

An electrolyte solution was obtained by dissolving 0.05 M $I_2$ (iodine), 0.5M LiI (lithium iodide), 0.58M tBP (tertiary butyl pyridine) and 0.6M DMPII (ionic solution) in MeCN (acetonitrile).

A platinum catalyst of a counter electrode is deposited on an ITO film formed on a glass substrate in a thickness of about 10 nm by way of sputtering. The counter electrode was laminated with the working electrode by using an adhesive consisting of an ionomer resin of a thermoplastic sheet form, followed by heat-compression in 100 °C. Then, the electrode solution was filled in the assembled cell and sealed to obtain a photoelectric conversion device.

The photoelectric conversion devices obtained from the examples and comparative examples were used as dye-sensitized solar cells and the characteristics thereof were evaluated by using AM1.5 solar stimulator as a light source. The preparation conditions of the photoelectric conversion devices and the results of I-V measurements are shown in the following Tables.

<Comparative Examples>

In comparative examples, the adsorption condition in which an unit of the adsorption amount is (nmol/cm$^2$)/ $\mu$m was measured in the static state of the electrolyte solution at room temperature in the air, by using N719 as an adsorbing dye. The adsorption was carved out for 6 to 8 hours. The working electrode substrate obtained by using the same porous titanium oxide film was used to assemble a photoelectric conversion device, and the light I-V characteristics thereof was examined at each time intervals for 12 hours. The measurements for light I-V characteristics are shown in Table 1, and the measurements for adsorption amount, Table 2.

[Table 1]

| Adsorption Time (h) | Film Thickness ($\mu$m) | Voc (V) | Jsc (mA/cm$^2$) | FF | Efficiency (%) |
|---|---|---|---|---|---|
| 2 | 15.5 | 0.721 | 11.0 | 0.632 | 5.03 |
| 5 | 15.4 | 0.730 | 14.1 | 0.598 | 6.22 |
| 6 | 15.4 | 0.738 | 15.1 | 0.610 | 6.81 |
| 12 | 15.2 | 0.735 | 14.7 | 0.631 | 6.83 |

[Table 2]

| Adsorption Time (h) | 1 | 2 | 3 | 5 | 6 | 8 | 10 | 12 |
|---|---|---|---|---|---|---|---|---|
| Adsorption Amount | 3.4 | 5.3 | 6.0 | 7.5 | 8.1 | 8.6 | 8.8 | 8.5 |

As shown in Table 1, there is a difference in the efficiencies of the adsorption time of 5 hours and 6 hours, while the difference of the efficiency is small for the adsorption time of 6 hours or more. Also, as can be seen from Table 2, in order to provide a sufficient efficiency, the porous film obtained from the titanium oxide paste used in this experiment requires an adsorption amount of 8 nmol/cm$^2$ or more per the film thickness of about 1 $\mu$m.

<Influence of Atmosphere>

To examine the influence of atmosphere which affects the dye adsorption, a dye solution was placed in a pressure vessel capable of including carbon dioxide or nitrogen to carry out adsorption experiments in the static state of the dye solution, and the results thereof are shown in Tables 3 to 5. Table 4 is for the adsorption experiment at a pressure of 0.5 MPa under carbon dioxide atmosphere. As shown in Table 3, the adsorption time can be shortened under carbon dioxide atmosphere as compared with nitrogen atmosphere. Specifically, when the adsorption time is 4 hours or more at a pressure of 0.2 MPa under carbon dioxide atmosphere, the adsorption amount is similar to that in the air, while the adsorption amount under nitrogen atmosphere has no distinct difference with that in the air. Also, as shown in Table 5, the adsorption amount is increased by raising the pressure of carbon dioxide atmosphere for the same adsorption time. Accordingly, the adsorption time can be shortened by the control of atmosphere together with the flow of a photosensitizing dye solution in the following examples.

[Table 3]

| Adsorption Time (h) | 1 | 2 | 4 | 6 | 8 | 12 |
|---|---|---|---|---|---|---|
| Adsorption Amount under $N_2$ 0.2Mpa | 3 | 5.6 | 7.1 | 7.7 | 8.4 | 8.1 |
| Adsorption Amount under $CO_2$ 0.2MPa | 5.1 | 6.7 | 8.2 | 8.1 | 8.4 | 8.6 |

[Table 4]

| Adsorption Time (h) | Adsorption Amount | Film Thickness ($\mu$m) | Voc (V) | Jsc (mA/cm2) | FF | Efficiency (%) |
|---|---|---|---|---|---|---|
| 1 | 5.3 | 15.0 | 0.722 | 10.4 | 0.649 | 4.87 |
| 2 | 7.3 | 15.0 | 0.721 | 13.3 | 0.651 | 6.27 |
| 4 | 8.7 | 14.7 | 0.744 | 15.2 | 0.607 | 6.68 |
| 8 | 8.8 | 14.5 | 0.721 | 15.6 | 0.613 | 6.88 |

[Table 5]

| $CO_2$ Pressure (MPa) | 0.1 | 0.2 | 0.3 | 0.4 | 0.5 |
|---|---|---|---|---|---|
| Adsorption Amount After 4 hours | 7.8 | 8.2 | 8.7 | 8.4 | 8.7 |

<Example 1>

As an example 1, the electrode substrate was attached in the inner wall of a closed vessel as illustrated in **FIG. 1**. The temperature of the solution was a room temperature 20 °C. Near the vessel wall, a rotation velocity (which corresponds to Vr) in the direction of a tangent line drawn to the circle was measured to 27 cm/s, 36 cm/s and 47 cm/s, respectively. The adsorption time was 10, 30, 60 and 120 minutes.

<Example 2>

As an example 2, the rotating disk electrode of a configuration as illustrated in **FIG. 2** was used to form convection current. The velocity of the fluid in a direction perpendicular to the rotating disk electrode and the velocity of the fluid in a direction parallel to the rotating disk electrode were calculated in the vicinity of the rotating disk electrode (1 mm of y direction and 2.5 mm of r direction on the basis of the glass surface and the circular center of the cylindrical electrode). The values calculated above and the dye adsorption amount were examined. The electrode installed in the rotating disk electrode was prepared by D paste applying a porous titanium oxide paste in the range of 5mm $\times$ 5 mm on the center of a circular borosilicate glass having a size of 0.7 mm thickness and 15 mm diameter, followed by calcinating so as to have a thickness of 15 $\mu$m $\leq$ 0.5 $\mu$m. Vy and Vr were calculated at 300 rpm, 500 rpm and 1000 rpm, respectively, and the results thereof are shown in Table 6.

[Table 6]

| Rpm | Vy (cm/s) | Vr (cm/s) |
|---|---|---|
| 300 | 7.3 | 18.2 |
| 500 | 15.7 | 39.2 |
| 1000 | 44.4 | 111.0 |

The values shown in Table 6 are similar to the rotation velocity in Vr direction for the stirrer. The transfer velocity of the dye in the porous film having a thickness of about 15 $\mu$m was estimated to about several ten $\mu$m/s in the Vy direction and several mm/s at the position of 2.5 mm from the center in the Vr direction. Each of the dye adsorption amount for the stirrer at Vr = 36 cm/s and for the rotating disk electrode at Vr = 39.2 cm/s under the room temperature was measured respectively, and the results thereof are shown in Table 7.

Table 7

| Adsorption Time (min) | 10 | 30 | 60 | 120 |
|---|---|---|---|---|
| Adsorption amount for Stirrer (Example 1) | 2.7 | 4.5 | 6.4 | 9.2 |
| Adsorption amount for Rotating Disk Electrode (Example 2) | 5.9 | 8.0 | 8.3 | 9.1 |

In the rotation of the stirrer, although the flow in the Vy direction cannot be actually measured, it can be easily seen that the adsorption rate is low as compared with the rotating disk electrode.

As shown in Tables 1 and 2, the cell prepared by using the working electrode having a dye adsorption amount of 8 $(nmol/cm^2)/\mu M$ or more exhibits sufficient photoelectric conversion efficiency. Thereby, while the prior dye adsorption was carried out for 6 hours or more under air atmosphere and 4 hours or more under carbon dioxide atmosphere, the dye adsorption device capable of generating the flow of a dye solution such as the rotating disk electrode can shorten the adsorption time to 30 minutes. Also, the adsorption time can be shortened to 2 hours by the rotation of the stirrer. This results from the flow rate of the dye solution (the transfer rate of the dye) which is higher than the diffusion rate of a dye solution having no flow.

<Example 3>

The solution was rotated by a stirrer to obtain a transfer rate of Vr = 26.8 cm/s in the horizontal direction of the solution. The solution was maintained at a constant temperature and refluxed by sealing a vessel so that the concentration is maintained constant. Also, the temperature was raised to increase the vapor pressure of ethanol, leading to the inner pressure rise of the vessel. In this regard, the adsorption amount was measured for the case of pressure 0.3 mM and temperature 40 °C, the case of pressure 0.9 mM and temperature 40 °C and the case of pressure 0.3 mM and temperature 60 °C, together with the case of pressure 0.3 mM, temperature 60 °C, and Vr = 0. The results are shown in Table 8.

[Table 8]

| Adsorption Time(min) | 10 | 30 | 60 | 120 |
|---|---|---|---|---|
| Adsorption Amount at 0.3mM, 40□, Vr = 26.8cm/s | 2.6 | 5.7 | 6.7 | 7.9 |
| Adsorption Amount at 0.9mM, 40□, Vr= 26.8cm/s | 8.5 | 10.1 | 10.0 | 11.4 |
| Adsorption Amount at 0.3mM, 60□, Vr=26.8cm/s | 5.6 | 8.3 | - | - |
| Adsorption Amount at 0.3mM, 60□, Vr=0 | 3.5 | 8.3 | 9.1 | - |

As shown in Table 8, in the temperature of 40 °C, the adsorption amount was not substantially affected by the temperature of the solution and the rise of inner pressure, thereby obtaining the same tendency as the results of the adsorption experiment at Vr = 36 cm/s in air. The adsorption time of about 2 hours was not changed. In the temperature of 60 °C, the adsorption amount was affected by the temperature of the solution and the rise of inner pressure, thereby shortening the adsorption time up to 30 minutes. The adsorption at 60 °C was not affected by rotation. When the inner pressure is 0.9 mM, the adsorption amount increases at the adsorption times of 10 minutes and after that, which is considered to be affected by the association between dye particles. Thus, the adsorption time can be changed by pressure and temperature.

<Example 4>

The black dye solution was provided with the flow by stirrer in a direction parallel to the substrate at Vr = 36 cm/s under the closed state of 40 °C to measure the adsorption amount of the dye as compared with that under static state. The results are shown in Table 9 in which the unit of the adsorption amount is $(nmol/cm^2)/\mu m$.

[Table 9]

| Adsorption Time (min) | 0.5 | 1 | 2 | 3 | 6 | 24 |
|---|---|---|---|---|---|---|
| Adsorption Amount of Black Dye Under Static State | - | 2.5 | - | 5.5 | 8.8 | 9.0 |
| Adsorption Amount of Black Dye at Vr = 36cm/s | 5.4 | 8.1 | 8.2 | 8.7 | - | - |

The adsorption amount capable of providing a sufficient photoelectric conversion efficiency for a dye-sensitized solar cell was obtained at the adsorption time of 1 hour, similarly to N719.

<Example 5>

A porous thin film of titanium oxide having a size of 25 mm $\times$ 25 mm was formed on glass substrate having a FTO film with a size of 30 mm $\times$ 30 mm $\times$ 30 mm in 15 $\mu$m $\leq$ 0.5 $\mu$m. Therein, the solution of dye dissolved in ethanol was dropped to the center at the intervals of about 5 seconds with rotating the substrate by using spin coater at 300 rpm. The adsorption time and the adsorption amount were measured. The results thereof are shown in Table 10.
[Table 10]

| Adsorption Time (min) Spin | 10 | 30 | 60 |
|---|---|---|---|
| coater | 1.0 | 2.4 | 5.4 |

As shown in Table 10, the adsorption amount according to Example 5 was increased as compared with that of comparative example for the same adsorption time, that is, the adsorption time can be shortened. Also, the titanium oxide film was formed on the FTO film-formed glass substrate in the state that the center part thereof was partially absent, and the dye solution was dropped in the center part with rotating the substrate by using spin coater at 300 rpm. Thereafter, the solution comprising black dye was dropped in the top of the film, to obtain a two-layered porous film.

<Example 6>

The solution of D149, an indoline-based organic dye was provided with the flow by stirrer in a horizontal direction to the substrate at Vr = 36 cm/s under the closed state of 40 °C to measure the adsorption time and the adsorption amount of the dye. The results are shown in Table 11 in which the unit of the adsorption amount is (nmol/cm$^2$)/$\mu$m.
[Table 11]

| Adsorption Time (min) | 10 | 30 | 60 |
|---|---|---|---|
| Adsorption Amount of D149 Under Static State | 2.9 | 6.9 | 9.2 |
| Adsorption Amount of D 149 at Vr=36cm/s, 40°C | 15.6 | 17.2 | 17.1 |

The measurements are compared with the adsorption amount of normal static state based on the light absorption degree. As a result, the solution of the organic dye having the flow thereof can shorten the adsorption time to 1/6 as compared with the static state thereof.

<Example 7>

A porous film (Solaronix HT/sp) consisting of titania particles having high penetrability which was described in Patent Document 3 was formed on an FTO film in a thickness of 15 $\mu$m, and a porous film (shokubai kasei 200C) consisting of titania particles having a size of about 200 nm and high scattering property in a thickness of 1 $\mu$m thereon. As tandem structure described in Patent Document 9, a porous film (Solaronix HT/sp) consisting of titania particles having high penetrability was formed on an FTO film in a thickness of 10 $\mu$m, and an FTO film was deposited in a thickness of about 100 nm thereon, to prepare a substrate.
The stirrer generated the flow in a direction parallel to the substrate at Vr = 27 cm/s and the dye N 719 was adsorbed to the working electrode under the closed vessel of 60 °C. For the comparison, the dye N 719 was adsorbed under static state of the room temperature 20 °C. The results are shown in Table 12 in which the unit of the adsorption amount is (nmol/cm$^2$)/$\mu$m.
[Table 12]

| Adsorption Time (h) | 0.5 | 1 | 16 |
|---|---|---|---|
| Patent Document 3, Titania, Surface Protrusions, Static State | - | - | 10.9 |
| Patent Document 3, Titania, Surface Protrusions, Vr = 27 | 4.6 | 9.8 | - |
| Patent Document 9, Tandem, Static State | - | - | 12.7 |
| Patent Document 9, Tandem, Vr = 27 | 11.9 | 14.5 | - |

As shown in Table 12, the solution having the flow thereof can be adsorbed for about 1 hour to the substrate. Also, the tandem structure having the surface covered with the dense FTO film to have the difficulty in adsorption, exhibited an efficient adsorption by the generation of the solution flow. The film delamination of the working electrode by the rotation was not observed.

<Example 8>

A porous film (Solaronix D/sp) consisting of titania particles having scattering property was deposited on an FTO film having large protrusions of silica particles between the FTO film and the glass substrate in a thickness of 15 $\mu$m, as described in Patent Document 7, to prepare a working electrode. On the other hand, a porous film (Solaronix D/sp) consisting of titania particles having scattering property was deposited on an FTO film whose surface was polished for evenness in a thickness of 15 $\mu$m, as described in Patent Document 8, to prepare a working electrode. A porous film (Solaronix D/sp) consisting of titania particles having scattering property was deposited on a stainless mesh, as described in Patent Document 11, in which the thickness thereof was not measured.
The stirrer generated the flow in a direction parallel to the substrate at Vr = 27 cm/s and the dye N 719 was adsorbed to the working electrode under the closed vessel of 60 °C. For the comparison, the dye N 719 was adsorbed under static state of the room temperature 20 °C. The results are shown in Table 13 in which the unit of the adsorption amount is (nmol/cm$^2$)/$\mu$m.
[Table 13]

| Adsorption Time (h) | 0.5 | 1 | 16 |
|---|---|---|---|
| Patent Document 7, Protruded Glass Substrate, Static State | - | - | 9.4 |
| Patent Document 7, Protruded Glass Substrate, Vr = 27 | 5.0 | 9.5 | |
| Patent Document 8, Surface-polished FTO, Static State | - | - | 10.3 |
| Patent Document 8, Surface-polished FTO, Vr = 27 | 5.1 | 9.4 | - |
| Patent Document 11, SUS mesh, Static State | - | - | 40.6 |
| Patent Document 11, SUS mesh, Vr = 27 | 58.0 | - | - |

As shown in Table 13, the solution having the flow thereof can be adsorbed for about 1 hour to the substrate. Particularly, on the stainless mesh, the adsorption can be carried out within 30 minutes, which is considered to be affected by the surface structure thereof. Also, the film delamination of the working electrode by the rotation was not observed.

<The application of potential>

A working electrode of a porous titanium oxide film prepared on an FTO film which was formed on substrate of a glass substrate was in part dipped in a N719 dye-dissolved solution, and the part of the electrode which was not dipped in the solution was attached with lead line. Meanwhile, platinum was used in a counter electrode and a reference electrode. Then, a potential of 0.8 V or 3.0 V vs. Pt was applied and a dye adsorption was carried out in the static state of the solution under the conditions of atmospheric pressure and room temperature. The results thereof are shown in Tables 14 to 16. Table 14 is to show the results when the potential is 0.8 V, and Tables 15 and 16, the results when the potential is 3.0 V. In Table 16, the unit of the adsorption amount is (nmol/cm$^2$)/$\mu$m.
| Adsorption Time (h) | Thickness (μm) | Voc (V) | Jsc(mA/cm2) | FF | Efficiency(%) |
|---|---|---|---|---|---|
| 1 | 14.7 | 0.711 | 11.56 | 0.634 | 5.21 |
| 2 | 15.5 | 0.716 | 13.40 | 0.648 | 6.22 |
| 3 | 15.4 | 0.725 | 14.38 | 0.646 | 6.74 |

[Table 15]

| Adsorption Time (min) | Thickness (μm) | Voc (V) | Jsc(mA/cm2) | FF | Efficiency (%) |
|---|---|---|---|---|---|
| 10 | 15.0 | 0.659 | 5.62 | 0.660 | 2.45 |
| 20 | 14.9 | 0.680 | 8.42 | 0.669 | 3.83 |
| 30 | 15.5 | 0.655 | 4.66 | 0.695 | 2.12 |
| 40 | 15.5 | 0.685 | 7.20 | 0.590 | 2.91 |
| 50 | 14.9 | 0.660 | 9.56 | 0.618 | 3.90 |

[Table 16]

| Adsorption Time (min) | 10 | 30 | 60 |
|---|---|---|---|
| Adsorption Amount at Dye 3V | 3.0 | 5.6 | 6.9 |

As shown in Table 14, the application of a potential of 0.8 V can shorten the time of the dye adsorption as compared with the case of applying no potential in Table 1. Also, when the applied potential is 3.0 V, the dye adsorption can be carried out for a shorter time than under the conditions of normal pressure and room temperature or under carbon dioxide atmosphere, however the decomposition of the dye was generated, thereby reducing the efficiency. Accordingly, it is preferable to apply the potential below 3.0 V.

Thus, the application of the potential can shorten the time of the dye adsorption. Accordingly, the application of the potential as well as the generation of the flow of a dye photosensitizing solution can more and more shorten the time of the dye adsorption.

<Example 9>

In order to shorten the time of the dye adsorption, it is considered that the application of ultrasonic waves is useful. When the ultrasonic waves was applied to titania which is a porous metal oxide semiconductor layer deposited by each of the methods described in Examples 1 to 8, the film of titania was delaminated.

In order to obtain a strong structure of the porous metal oxide layer without delamination on applying the ultrasonic waves, the solution of titanyl dissolved in nitric acid was applied on an FTO film to prepare a dense titania layer (pre-treatment), which was again treated with the solution of titanyl in nitric acid to prepare a dense titania layer (post-treatment). A working electrode having such a structure was not subjected to the delamination of the porous metal oxide layer on applying the ultrasonic waves.

Such a dense titania layer was formed on FTO deposited on a glass substrate, and a porous layer of titania particles was formed in a thickness of 12 μm thereon, also post-treatment with the solution of titanyl in nitric acid was performed, followed by annealing the substrate at 500 °C. The substrate was dipped in 0.3 mM solution containing N719 dye, and an ultrasonic wave of 90 W was applied thereto. The amount of dye adsorbed to the porous film was measured. Meanwhile, the porous film was not subjected to delamination due to the ultrasonic waves. The results are shown in Table 17 in which the unit of the adsorption amount is $(nmol/cm^2)/\mu m$.

[Table 17]

| Ultrasonic waves Application Time (min) | 15 | 30 | 60 |
|---|---|---|---|
| Dye Adsorption Amount at 90 W | 3.2 | 4.5 | 5.5 |

As shown in Table 17, on applying the ultrasonic waves, the dye adsorption amount for a short time of 30 minutes was almost equal to the amount adsorbed in the presence of the solution flow by rotation of the stirrer.

Thus, according to the present disclosure, it is possible to provide a method and device for adsorption of a photosensitizing dye, a process and apparatus for producing a dye-sensitized solar cell, and a dye-sensitized solar cell, which can reduce production cost of a dye-sensitized solar cell and enhance the photoelectric conversion efficiency of the dye-sensitized solar cell in a system comprising a dye adsorption procedure. Also, although the present disclosure have been described by examples and comparative examples, these examples and comparative examples are not intended to limit the scope of the present disclosure, and a variety of changes may be encompassed in the present disclosure. For example, the control of pressure, atmosphere, temperature and potential as well as the application of ultrasonic waves, together with the generation of the flow for the solution can promote the reduction of the dye adsorption time, and they may be used to be combined.

## INDUSTRIAL USE OF THE PRESENT DISCLOSURE

The present disclosure can be effective in the preparation of a dye-sensitized solar cell, and thus has industrial applicability.

## EXPLANATION OF REFERENCE NUMERALS

1: vessel, 2: heater, 3: working electrode, 4: stirrer, 5: solution containing a dye

## Claims

1. A method for adsorption of a photosensitizing dye, comprising adsorbing the photosensitizing dye to an electrode material layer that functions as a working electrode of a dye-sensitized solar cell, within a reaction vessel containing a solution of the photosensitizing dye,
   wherein a flow of the photosensitizing dye solution is generated by means of a flow generation part in at least one of a direction perpendicular to the electrode material layer and a direction parallel thereto, and the flow rate of the photosensitizing dye solution to the electrode material layer is higher than the diffusion velocity of the photosensitizing dye.

2. The method of Claim 1, wherein the flow of the photosensitizing dye solution is generated by rotating a substrate on which the electrode material layer is formed, in the reaction vessel.

3. The method of Claim 1 or 2, wherein the reaction vessel has at least one unit for controlling a pressure within the reaction vessel.

4. The method of any one of Claims 1 to 3, wherein the reaction vessel has at least one unit for controlling a temperature within the reaction vessel.

5. The method of any one of Claims 1 to 4, wherein the reaction vessel has at least one unit for applying potential in the electrode material layer within the reaction vessel.

6. The method of any one of Claims 1 to 5, wherein the electrode material layer is a porous metal oxide semiconductor layer.

7. The method of any one of Claims 1 to 6, wherein the electrode material layer has a dense titania layer formed by using the solution of titanyl in nitric acid.

8. The method of any one of Claims 1 to 7, wherein the photosensitizing dye is a Ru complex-based photosensitizing dye or an organic photosensitizing dye.

9. A method for producing a dye-sensitized solar cell, which comprises forming a film to be an electrode material layer after calcination, calcining the film, and adsorbing a photosensitizing dye to the electrode material layer in a successive production line to produce a working electrode of the dye-sensitized solar cell, wherein the photosensitizing dye adsorption is performed by the method of any one of Claims 1 to 8.

10. A device for adsorption of a photosensitizing dye, which adsorbs the photosensitizing dye to an electrode material layer that functions as a working electrode of a dye-sensitized solar cell, within a reaction vessel containing a solution of the photosensitizing dye, comprising a flow generation part for generating a flow of the photosensitizing dye solution in at least one of a direction perpendicular to the electrode material layer and a direction parallel thereto, wherein the flow rate of the photosensitizing dye solution to the electrode material layer, which is generated by the flow generation part, is higher than the diffusion velocity of the photosensitizing dye.

11. The device of Claim 10, wherein the flow generation part generates the flow of the photosensitizing dye solution by rotating a substrate on which the electrode material layer is formed, in the reaction vessel.

12. The device of Claim 10 or 11, wherein the reaction vessel has at least one unit for controlling a pressure within the reaction vessel.

13. The device of any one of Claims 10 to 12, wherein the reaction vessel has at least one unit for controlling a temperature within the reaction vessel.

14. The device of any one of Claims 10 to 13, wherein the reaction vessel has at least one unit for applying potential in the electrode material layer within the reaction vessel.

15. The device of any one of Claims 10 to 14, wherein the electrode material layer is a porous metal oxide semiconductor layer.

16. The device of any one of Claims 10 to 15, wherein the electrode material layer has a dense titania layer formed by using the solution of titanyl in nitric acid.

17. The device of any one of Claims 10 to 16, wherein the photosensitizing dye is a Ru complex-based photosensitizing dye or an organic photosensitizing dye.

18. An apparatus for producing a dye-sensitized solar cell, which comprises forming a film to be an electrode material layer after calcination, calcining the film, and adsorbing a photosensitizing dye to the electrode material layer in a successive production line to produce a working electrode of the dye-sensitized solar cell, wherein the photosensitizing dye adsorption is performed by the device of any one of Claims 10 to 17.

19. A dye-sensitized solar cell which adsorbs a photosensitizing dye to an electrode material layer that functions as a working electrode, wherein the photosensitizing dye adsorption to the electrode material layer is performed by the method of any one of Claims 1 to 8.

FIG. 1

FIG. 2

FIG. 3

# FIG. 4

# FIG. 5

FIG. 6

FIG. 7

FIG. 8

FIG. 9

# FIG. 10

# FIG. 11

## FIG. 12

## FIG. 13

FIG. 14

FIG. 15

## INTERNATIONAL SEARCH REPORT

| | International application No. |
|---|---|
| | PCT/JP2010/001242 |

**A. CLASSIFICATION OF SUBJECT MATTER**
*H01M14/00(2006.01)i, H01L31/04(2006.01)i*

According to International Patent Classification (IPC) or to both national classification and IPC

**B. FIELDS SEARCHED**

Minimum documentation searched (classification system followed by classification symbols)
H01M14/00, H01L31/04

Documentation searched other than minimum documentation to the extent that such documents are included in the fields searched
| | | | |
|---|---|---|---|
| Jitsuyo Shinan Koho | 1922–1996 | Jitsuyo Shinan Toroku Koho | 1996–2010 |
| Kokai Jitsuyo Shinan Koho | 1971–2010 | Toroku Jitsuyo Shinan Koho | 1994–2010 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X <br> Y <br><br> A | JP 2001-185244 A (Sharp Corp.),<br>06 July 2001 (06.07.2001),<br>claims; paragraph [0018]<br>& US 2001/0004901 A1 | 1,6,8-10,15,<br>17-19<br>3-5,7,12-14,<br>16<br>2,11 |
| X <br> Y <br><br> A | JP 2000-348783 A (Nikon Corp.),<br>15 December 2000 (15.12.2000),<br>claims; paragraph [0023]<br>(Family: none) | 1,6,8-10,15,<br>17-19<br>3-5,7,12-14,<br>16<br>2,11 |
| Y | JP 2003-249274 A (Sharp Corp.),<br>05 September 2003 (05.09.2003),<br>claims; paragraph [0034]<br>(Family: none) | 3-4,12-13 |

| ☒ Further documents are listed in the continuation of Box C. | ☐ See patent family annex. |
|---|---|

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 30 March, 2010 (30.03.10) | 06 April, 2010 (06.04.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

| International application No. |
| --- |
| PCT/JP2010/001242 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 2007-35591 A  (Sharp Corp.), 08 February 2007 (08.02.2007), claims; paragraph [0065] (Family: none) | 3-4,12-13 |
| Y | JP 2008-258099 A  (JGC Catalysts and Chemicals Ltd.), 23 October 2008 (23.10.2008), claims (Family: none) | 5,14 |
| Y | JP 2009-9740 A  (Kyushu Institute of Technology), 15 January 2009 (15.01.2009), claims; paragraph [0022] (Family: none) | 7,16 |

Form PCT/ISA/210 (continuation of second sheet) (July 2009)

EP 2 403 051 A1

**INTERNATIONAL SEARCH REPORT**

International application No.

PCT/JP2010/001242

**Box No. II      Observations where certain claims were found unsearchable (Continuation of item 2 of first sheet)**

This international search report has not been established in respect of certain claims under Article 17(2)(a) for the following reasons:

1. ☐  Claims Nos.:
        because they relate to subject matter not required to be searched by this Authority, namely:

2. ☐  Claims Nos.:
        because they relate to parts of the international application that do not comply with the prescribed requirements to such an extent that no meaningful international search can be carried out, specifically:

3. ☐  Claims Nos.:
        because they are dependent claims and are not drafted in accordance with the second and third sentences of Rule 6.4(a).

**Box No. III      Observations where unity of invention is lacking (Continuation of item 3 of first sheet)**

This International Searching Authority found multiple inventions in this international application, as follows:
    In order that a group of inventions described in claims satisfy the requirement of unity of invention, it is required that a special technical feature for so linking the group of inventions as to form a single general inventive concept exists.  But, the group of inventions in claims 1 - 19 is deemed to be linked by only the matter described in claim 1.
    However, the above-said matter cannot be a special technical feature, since the matter is described in the prior-art documents, for example, JP 2001-185244 A (Sharp Corp.), 6 July 2001 (06.07.2001) and so on.
                                                            (continued to extra sheet)

1. ☐  As all required additional search fees were timely paid by the applicant, this international search report covers all searchable claims.

2. ☒  As all searchable claims could be searched without effort justifying additional fees, this Authority did not invite payment of additional fees.

3. ☐  As only some of the required additional search fees were timely paid by the applicant, this international search report covers only those claims for which fees were paid, specifically claims Nos.:

4. ☐  No required additional search fees were timely paid by the applicant.   Consequently, this international search report is restricted to the invention first mentioned in the claims; it is covered by claims Nos.:

**Remark on Protest**      ☐  The additional search fees were accompanied by the applicant's protest and, where applicable, the payment of a protest fee.

☐  The additional search fees were accompanied by the applicant's protest but the applicable protest fee was not paid within the time limit specified in the invitation.

☐  No protest accompanied the payment of additional search fees.

Form PCT/ISA/210 (continuation of first sheet (2)) (July 2009)

| INTERNATIONAL SEARCH REPORT | International application No. |
|---|---|
| | PCT/JP2010/001242 |

Continuation of Box No.III of continuation of first sheet(2)

Consequently, among the group of inventions in claims 1 - 19, there is no special technical feature for so linking those inventions as to form a single general inventive concept. Therefore, it is obvious that the group of inventions in claims 1 - 19 does not satisfy the requirement of unity of invention.

Form PCT/ISA/210 (extra sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008071535 A
- JP 2003197280 A
- JP 2001076776 A
- JP 2007128869 A
- JP 2006049082 A
- JP 2006032227 A
- JP 2006009740 A
- WO 200638495 PCT
- JP 2008016405 A
- JP 2001283941 A
- JP 2007305351 A
- JP 7249790 A

**Non-patent literature cited in the description**

- Electrokinetic phenomenon. **Nobuatsu Watanabe ; Shaw Watanabe ; Yasukatsu Tamai et al.** Surface and Interface. KYORITSU SHUPPAN Co., LTD, 1973, 7-27
- **A. J. Bard ; L. R. Faulkner.** Electrochemical Methods fundamentals and Applications. John Wiley & Sons, Inc, 335-336